# EUROPEAN PATENT APPLICATION

(11) **EP 4 682 884 A1**
(43) Date of publication of application: **21.01.2026**
(21) Application number: 25188661.0
(22) Date of filing: 10.07.2025
(51) Int. Cl.: G11C 11/419

(54) **WRITE ASSIST SCHEME FOR ULTRA LOW VOLTAGE MEMORY DESIGN ENABLEMENT**

(30) Priority: 16.07.2024 US 202463672075 P; 07.07.2025 US 202519261855
(71) Applicant: STMicroelectronics International N.V., 1228 Plan-les-Ouates, Geneva (CH)
(72) Inventor: VERMA, Praveen Kumar, 201310 GREATER NOIDA (IN); SHRIVASTAVA, Sant Swaroop, 282005 AGRA UTTAR PRADESH (IN)
(74) Representative: Casalonga

(57) **Abstract**

A memory array includes a write assist circuit that helps ensure that write operations can be effectively and efficiently performed in spite of low voltage supply levels. The write assist circuit includes a negative voltage generator that generates a negative voltage during write operations and applies the negative voltage to a bitline coupled to a selected memory cell. The negative voltage helps ensure that data is quickly and properly written to the memory cell. The write assist circuit also includes a leakage control circuit that helps reduce leakages associated with generation of the negative voltage by applying the negative voltage to other portions of the memory array in order to reduce leakage currents.

## Description

### BACKGROUND

### Technical Field

This present disclosure is related to computer memory, and more particularly, to write operations of computer memories.

### Description of the Related Art

In integrated circuit technology, there is a continuous push to reduce the area consumption of integrated circuit components so that the density of components of the integrated circuit can increase. In particular, the transistor dimensions continually decrease so that the number of transistors for a given amount of area can increase. In order to ensure that the transistors will not be damaged by supply voltages, as the size of transistors decreases, so do the magnitude of supply voltages. This both ensures that the transistors not be damaged, and reduces overall power consumption.

However, as supply voltages decrease, there are various difficulties associated with memory operations. For example, with reduced supply voltages, it can be difficult to quickly and effectively write data to memory cells.

All of the subject matter discussed in the Background section is not necessarily prior art and should not be assumed to be prior art merely as a result of its discussion in the Background section. Along these lines, any recognition of problems in the prior art discussed in the Background section or associated with such subject matter should not be treated as prior art unless expressly stated to be prior art. Instead, the discussion of any subject matter in the Background section should be treated as part of the inventor's approach to the particular problem, which, in and of itself, may also be inventive.

### BRIEF SUMMARY

Embodiments of the present disclosure provide a memory array including a write assist circuit that helps ensure that write operations can be effectively and efficiently performed in spite of low voltage supply levels. The write assist circuit includes a negative voltage generator generates a negative voltage (lower than ground) during write operations and applies the negative voltage to a bitline coupled to a selected memory cell. The negative voltage helps ensure that data is quickly and properly written to the memory cell. The write assist circuit also includes a leakage control circuit that helps reduce leakages associated with generation of the negative voltage. In particular, the leakage control circuit applies the negative voltage to other portions of the write assist circuit in order to reduce leakage currents.

The result of the write assist circuit including the leakage control circuit is that write operations are carried out more effectively. Furthermore, area consumption of the memory array is reduced, power consumption of the memory array is reduced, and the performance of the memory array is increased.

In one embodiment, the write assist circuit generates the negative voltage at a first node. A transistor is coupled between the first node and ground. In particular, the drain terminal of the transistor is coupled to the first node and the source terminal of the transistor is coupled to ground. The leakage control circuit selectively applies the negative voltage to the gate terminal of the transistor. This helps ensure that the transistor remains nonconducting during write operations, thereby reducing leakage currents and improving write operations.

In one embodiment, the memory array includes a plurality of columns of memory cells. Each column of memory cells is coupled to a pair of bit lines. During write operation, one bit line of each pair receives the negative voltage. The negative voltage can result in leakage currents in bit lines that are not selected for a write operation. Each pair of bit lines is coupled to a respective multiplexer. Advantageously, the leakage control circuit applies the negative voltage to a control terminal associated with the multiplexer of each unselected pair bit lines. This further helps to reduce the leakage currents associated with generation of a negative voltage during write operations.

In one embodiment, a method includes generating, with a write assist circuit of a memory array, a first negative voltage at a first node coupled to a drain terminal of a first transistor. The method includes applying the first negative voltage to a gate terminal of the first transistor and writing a data value to a selected memory cell of the memory array by applying the first negative voltage to a selected bitline from a plurality of bitlines of the memory array.

In one embodiment, a device includes a memory array including a plurality of memory cells and a plurality of bitlines coupled to the memory cells and a write assist circuit coupled to the memory array. The write assist circuit includes a negative voltage generator configured to generate a first negative voltage at a first node of the write assist circuit during a write operation of the memory cells. a first transistor having a gate terminal and a first source/drain terminal coupled to the first node, and a leakage control circuit configured to apply a second negative voltage to the gate terminal of the first transistor during a write operation of the memory array.

In one embodiment, a device includes a memory array including a plurality of memory cells and a plurality of bitlines. The memory array includes a write assist circuit configured to generate a first negative voltage and a second negative voltage during a write operation of the memory array and to apply the first negative voltage to a selected bitline of the plurality of bitlines during the write operation. The memory array includes a first inverter coupled to the memory array, wherein the write assist circuit is configured to supply the second negative voltage to a supply terminal of the first inverter during the write operation.

### BRIEF DESCRIPTION OF THE SEVERAL VIEWS OF THE DRAWINGS

Figure 1 is a schematic diagram of a memory array including a write assist circuit, in accordance with one embodiment.
Figure 2 is a schematic diagram of a memory array including a write assist circuit, in accordance with one embodiment.
Figure 3 illustrates graphs associated with write operations of a memory array, in accordance with one embodiment.
Figure 4 illustrates graphs associated with write operations of a memory array, in accordance with one embodiment.
Figure 5 illustrates graphs associated with write operations of a memory array, in accordance with one embodiment.
Figure 6 is a schematic diagram of a memory array including a write assist circuit, in accordance with one embodiment.
Figure 7 illustrates graphs associated with write operations of a memory array, in accordance with one embodiment.
Figure 8 illustrates graphs associated with write operations of a memory array, in accordance with one embodiment.
Figure 9 is a schematic diagram of a memory array including a write assist circuit, in accordance with one embodiment.
Figure 10 is a schematic diagram of a memory array including a write assist circuit, in accordance with one embodiment.
Figure 11 is a schematic diagram of a memory array including a write assist circuit, in accordance with one embodiment.
Figure 12 is a flow diagram of a method for operating a memory array, in accordance with one embodiment.

### DETAILED DESCRIPTION

In the ensuing description, various specific details are illustrated aimed at enabling an in-depth understanding of the embodiments. The embodiments may be provided without one or more of the specific details, or with other methods, components, materials, etc. In other cases, known structures, materials, or operations are not shown or described in detail so that various aspects of the embodiments will not be obscured.

Reference to "an embodiment" or "one embodiment" in the framework of this description is meant to indicate that a particular configuration, structure, or characteristic described in relation to the embodiment is comprised in at least one embodiment. Hence, phrases such as "in an embodiment", "in one embodiment", or the like that may be present in various points of this description do not necessarily refer to one and the same embodiment. Moreover, particular conformations, structures, or characteristics may be combined in any adequate way in one or more embodiments.

In the following description, certain specific details are set forth in order to provide a thorough understanding of various disclosed embodiments. However, one skilled in the relevant art will recognize that embodiments may be practiced without one or more of these specific details, or with other methods, components, materials, etc. In other instances, well-known algorithms associated with facial recognition, facial detection, and facial authentication have not been shown or described in detail, to avoid unnecessarily obscuring descriptions of the embodiments.

Unless the context requires otherwise, throughout the specification and claims which follow, the word "comprise" and variations thereof, such as, "comprises" and "comprising" are to be construed in an open, inclusive sense, that is as "including, but not limited to." Further, the terms "first," "second," and similar indicators of sequence are to be construed as interchangeable unless the context clearly dictates otherwise.

Reference throughout this specification to "one embodiment" or "an embodiment" means that a particular feature, structure or characteristic described in connection with the embodiment is included in at least one embodiment. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

As used in this specification and the appended claims, the singular forms "a," "an," and "the" include plural referents unless the content clearly dictates otherwise. It should also be noted that the term "or" is generally employed in its broadest sense, that is as meaning "and/or" unless the content clearly dictates otherwise.

As used herein, "source/drain terminal" can refer to a source terminal of a transistor or a drain terminal of a transistor.

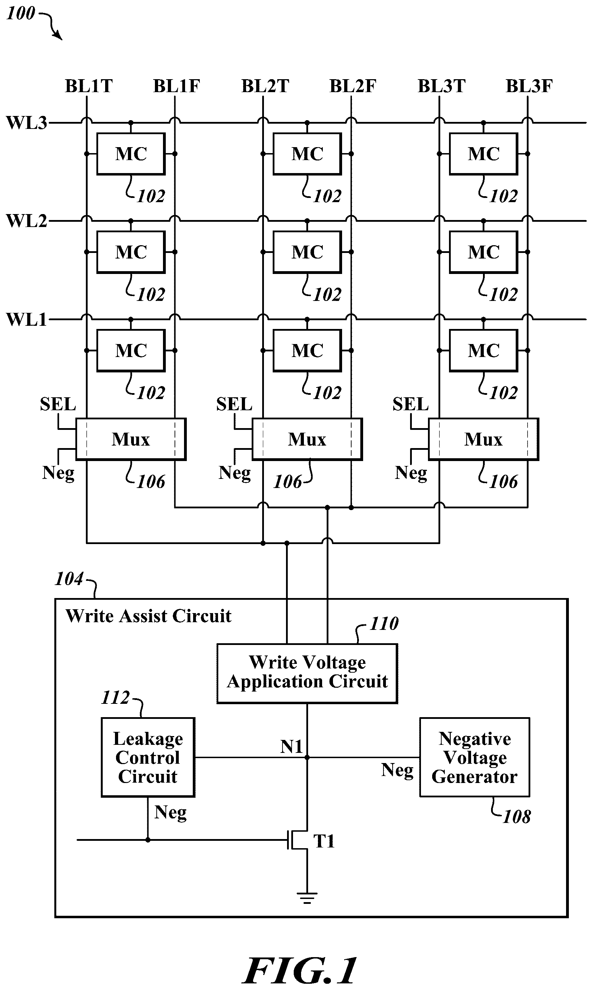

Figure 1 is a schematic diagram of a memory array 100, in accordance with one embodiment. The memory array 100 includes a plurality of memory cells 102 and a write assist circuit 104. The write assist circuit 104 includes a negative voltage generator 108 and a leakage control circuit 112. As will be set forth in more detail below, the components of the memory array 100 cooperate to ensure that write operations are effectively and efficiently performed.

The memory cells 102 are arranged in columns. Each column of memory cells is coupled to a pair of bit lines. Each pair bit lines includes a true bitline BLT and the false bitline BLF. More particularly, the first column of memory cells 102 is coupled to a first true bitline BL1T and a first false bitline BL1F. The second column of memory cells 102 is coupled to a second true bitline BL2T and a second false bitline BL2F. The third column of memory cells 102 is coupled to a third true bitline BL3T and a second false bitline BL3F. While Figure 1 illustrates only three columns of memory cells 102, in practice, the memory array 100 can include a large number of columns of memory cells 102. As used herein, the bit lines may be referred to as BL, BLT, or BLF without an associated column number if the description is related to the bitlines in general rather than to a particular bitline.

The memory cells 102 are also arranged in rows. Each row of memory cells 102 is coupled to a word line WL. A first row of memory cells is coupled to a word line WL1. A second row of memory cells is coupled to a word line WL2. A third row of memory cells is coupled to a word line WL3. While Figure 1 illustrates three rows of memory cells 102, in practice, the memory array 100 can include a large number of rows of memory cells 102.

The memory array 100 includes a plurality of multiplexers 106. More particularly, each pair of bit lines BLT/BLF is coupled to a respective multiplexer 106. The multiplexers 106 determine whether or not a pair bit lines will receive write voltages during a write operation. Further details regarding the multiplexers 106 will be provided below.

In one embodiment, the memory cells 102 are static random-access memory (SRAM) cells. Each SRAM cell includes a pair of cross coupled inverters, defining two data storage nodes. One of the data storage nodes is a true data storage node coupled to the true bitline BLT by an access transistor coupled to the word line. The other data storage node is a false data storage node coupled to the false bitline BLF by an access transistor coupled to the word line.

If a data value of 1 is to be written to a memory cell 102, a high-voltage value (e.g., VDD) is applied to the true bitline BLT, thereby bringing the true data storage node to high-voltage value. A low voltage value is applied to the false bitline BLF, thereby bringing the false data storage node to a low-voltage value.

If a data value of 0 is to be written to a memory cell 102, the low voltage value is applied to the true bitline BLT, thereby bringing the true data storage node to a low-voltage value. A high-voltage value supplied to the false bitline BLF, thereby bringing the false data storage node to high-voltage value. As will be described in more detail below, a negative voltage is applied to the bitline coupled to the data storage node to which 0 is being written.

The write assist circuit 104 includes the write voltage application circuit 110. The write voltage application circuit 110 applies write voltages to the bit lines. In one embodiment, during a write operation for a selected pair of bit lines, one of the bit lines will receive the high supply voltage (e.g., VDD, not shown) and the other will receive a negative voltage, as will be described in more detail below.

As can be seen, each of the true bitlines BLT are coupled together below the multiplexers 106. Each of the false bitlines BLF are coupled together below the multiplexers 106. During a write operation, the write voltage application circuit 110 applies VDD to one of the bitlines of each pair and applies a negative voltage to the other of the bit lines of each pair.

The write assist circuit 104 includes a negative voltage generator 108. During a write operation, the negative voltage generator 108 generates a negative voltage Neg on a first node N1. The negative voltage Neg is less than ground. Because Neg is less than ground, the effective voltage difference across terminals of the memory cell 102 during a write operation can be greater than VDD. This is different than a scenario in which ground is applied rather than Neg. If ground is applied rather than Neg, an effective voltage difference across terminals of the memory cell 102 during a write operation is VDD. As described previously, if VDD is small, the write operations may utilize a relatively large amount of time and they still not be effective. Accordingly, utilizing the negative voltage Neg during write operations can result in faster write times and more successful write operations.

In one embodiment, VDD is less than 1 V. In one embodiment, VDD is between 0.6 V and 0.8 V. In one embodiment, VDD is about 0.7 V. In one embodiment, Neg is between -130 mV and -180 mV. In one embodiment, Neg is about -150 mV. Other voltages can be utilized without departing from the scope of the present disclosure.

In one embodiment, the write assist circuit 104 includes a transistor T1. The transistor T1 is an NMOS transistor having a source terminal coupled to ground and the drain terminal coupled to the first node N1. Traditionally, an NMOS transistor having a source terminal coupled to ground can be turned off by applying ground to the gate terminal. This is because the gate to source voltage VGS is effectively 0, which is less than the threshold voltage of the transistor.

However, during a write operation in which the negative voltage generator 108 generates the negative voltage Neg, the drain terminal of the transistor T1 is brought to the negative voltage Neg. If ground is applied to the gate terminal of the transistor T1, then the drain terminal of T1 effectively acts as a source terminal with a lower voltage than the gate terminal. The result is that the transistor T1 begins to conduct a leakage current from ground. The leakage current has the effect of bringing the node N1 to ground. This not only consumes power, but write operations may not be properly performed if Neg is not low enough or does not stay low enough for a sufficient duration of time.

In order to reduce potential leakage currents, the write assist circuit 104 includes a leakage control circuit 112. The leakage control circuit 112 is coupled to the first node N1 and receives the negative voltage Neg when the negative voltage generator 108 generates the negative voltage Neg. The leakage control circuit 112 applies the negative voltage Neg to the gate terminal of the transistor T1. Because both the drain terminal and the gate terminal are at the negative voltage Neg, the transistor T1 remains substantially nonconducting during the write operation. The result is that leakage currents are reduced and the write operation can be performed effectively.

In one embodiment, each multiplexer 106 includes a selection input that receives a selection signal SEL. The selection signal SEL determines whether or not the voltages from the write voltage application circuit 110 will be applied to the corresponding pair of bit lines. As shown in Figure 1, each multiplexer 106 can also receive the negative voltage Neg in order to reduce leakage currents for non-selected pairs of bit lines, as will be described in more detail below. In practice, each multiplexer 106 includes a pair of transistors each in the conduction path of one of the respective bit lines. When a pair of bit lines is selected for a write operation, each of the transistors of the multiplexer 106 is turned on by receiving VDD on the gate terminal.

In one possible solution, for non-selected pairs of bit lines, the gate terminals of each of the transistors of the corresponding multiplexer 106 receives ground in order to turn the transistors off so that data will not be written to non-selected memory cells. However, as can be seen from the diagram of Figure 1, during a write operation all of the true bitlines or all of the false bitlines receive the negative voltage Neg below the multiplexers 106. If ground is used to turn off the transistors of the multiplexers 106 of the non-selected bit lines while the negative voltage Neg is applied to the source terminals of those transistors, the transistors may become partially conducting. The result is that leakage currents will be conducted by the non-selected bit lines. This is another source of unwanted power consumption and may result in dissipation of the negative voltage Neg before write operations can be successfully accomplished.

In one embodiment, the leakage control circuit 112 provides the negative voltage Neg as the low supply voltage to the multiplexers 106 associated with non-selected pairs of bit lines. The result is that the transistors of the non-selected multiplexers 106 are turned off by applying the negative voltage to the gate terminals. The result is that the transistors of the non-selected multiplexers 106 remained nonconducting. This reduces leakage currents and prevents dissipation of the negative voltage Neg. This results in successfully completed write operations. Figure 1 does not illustrate the high supply voltage VDD which is also utilized by the multiplexers 106.

In one embodiment, the negative voltage generator 108 includes one or more capacitors. The negative voltage is generated at the capacitor terminal(s) coupled to the first node. The presence of leakage currents, as described previously, can dissipate the negative voltage at the capacitor(s). Because the leakage control circuit 112 reduces leakage currents, smaller capacitors can be used for the negative voltage generator 108. The result is that the write assist circuit 104 saves a large amount of area compared to other possible solutions.

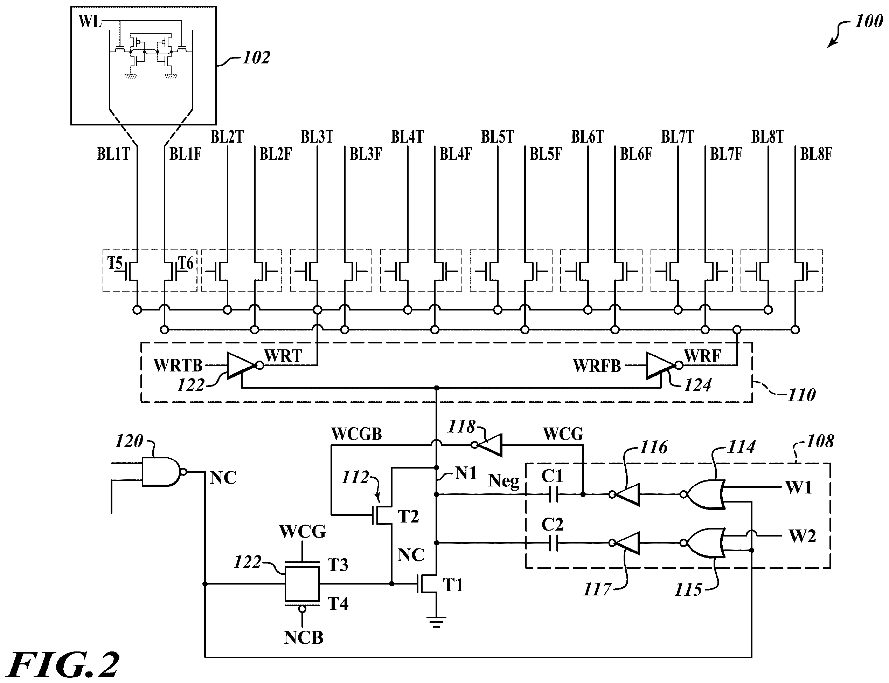

Figure 2 is a schematic diagram of a memory array 100, in accordance with one embodiment. The memory array 100 of Figure 2, is one example of a memory array 100 of Figure 1. Figure 2 illustrates a pairs of bit lines but only illustrates a single memory cell 102. In practice, a large number of memory cells 102 is coupled to each pair of bit lines.

The memory cell 102 is an SRAM memory cell including six transistors. For the transistors are arranged as cross coupled inverters. Two of the transistors function as control transistors coupled to the word line WL.

The write assist circuit 104 includes a negative voltage generator 108. The negative voltage generator 108 includes two capacitors C1 and C2, each having a first terminal coupled to the first node N1 and a second terminal coupled to an output of a respective inverter 116/117. The negative voltage generator 108 includes a pair of NOR gates 114/115 each having an output coupled to the input of the following inverter 116/117. Each of the NOR gates 114/115 has a first input coupled to the output of a NAND gate 120 and receiving a control signal NC that controls whether or not the negative voltage will be generated. The NOR gates 114/115 receives a respective signal W1/W2 on a second terminal.

Prior to generation of the negative voltage signal Neg, the first node N1 is at ground and the output of the inverters 116/117 is high. Accordingly there is a voltage difference across the terminals of the capacitors C1/C2, with the first terminal being lower than the second terminal. When control signal NC is received, the outputs of the inverters 116/117 goes low. This results in a negative voltage appearing at the first node N1. At this stage, the transistor T1 receives ground on the source terminal and the negative voltage Neg on its drain terminal.

In one embodiment, the capacitors C1/C2 are MOS capacitors. In the example of and NMOS capacitor C1/C2, the gate terminal receives WCG and the negative voltage NEG appears at the body terminal. In the example of a PMOS capacitor C1/C2, the body terminal receives WCG and the negative voltage NEG appears at the gate terminal. In one embodiment, the area of the MOS capacitor is 50 µm².

The leakage control circuit 112 includes an inverter 118, a transistor T2, and a pass gate 122. The input of the inverter 118 is coupled to the output of the inverter 116 and receives the signal WCG. The output of the inverter 118 is coupled to the gate terminal of the transistor T2. When WCG goes low in order to generate the negative voltage Neg, WCGB goes high, thereby turning on the transistor T2. When the transistor T2 is turned on, the negative voltage Neg is conducted through the transistor T2 to the gate terminal of the transistor T1, as the gate control signal GC. In this manner, the gate terminal of the transistor T1 receives a negative voltage and is turned off during the write operation.

The pass gate 122 includes an NMOS transistor T3 and a PMOS transistor T4. The pass gate 122 is coupled between the gate terminal of the transistor T1 and the output of the NAND gate 120. The transistor T3 receives WCG on its gate terminal. The transistor T4 receives NCB, the compliment of NC, on its gate terminal. During a write operation, the pass gate 122 is turned off so that the negative voltage can be applied to the gate terminal of the transistor T1.

The write voltage application circuit 110 includes an inverter 123 and an inverter 124. The output of the inverter 123 is coupled to the true bitlines below the multiplexers 106. The output of the inverter 124 is coupled to the false bitlines below the multiplexers 106. The input of the inverter 123 receives the complementary true write signal WRTB and outputs the true write signal WRT. The input of the inverter 124 receives the complementary false write signal WRFB and outputs the false write signal WRF.

The inverters 123/124 each include a low supply terminal coupled to the first node N1. Accordingly, the inverters 123/124 receive a negative voltage NEG on their low supply terminals during write operations. Outside of write operations, the inverters 123/124 receive ground voltage on their low supply terminals. Though not shown, the inverters 123/124 each have a high supply terminal that receives VDD.

During a write operation, if the true bitline is to be written with 0, then WRTB is high, causing the inverter 123 to supply the negative voltage NEG to the true bitlines. WRFB is low, causing the inverter 124 to supply the high supply voltage VDD to the false bitlines. During a write operation, the true bitline is rewritten with 1, then WRFT is low, causing the inverter 123 to supply the high supply voltage VDD to the true bitlines. WRFB is high, causing the inverter 124 to supply the negative voltage to the false bitlines.

As described previously, each multiplexer 106 includes an NMOS transistor T5 coupled in the current conduction path of the true bitline BLT and controlling whether or not the true bitline can receive the write voltage (Neg or VDD, as the case may be). Each multiplexer 106 includes an NMOS transistor T6 coupled to the current conduction path of the false bitline BLF and controlling whether or not the false bitline BLF can receive the write voltage.

The memory array of Figure 2 provides many benefits. Capacitor area can be significantly reduced. The negative voltage peak can be lower (more negative). The duration of the negative voltage boost is increased. The duration of a write operation can be significantly reduced. The power consumption of a write operation can also be significantly reduced.

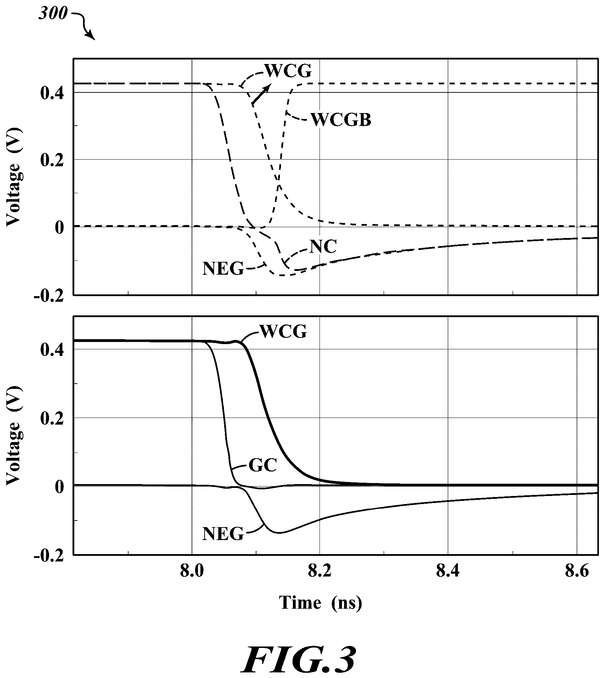

Figure 3 is a graph 300 illustrating a plurality of curves associated with a write operation of the memory array 100 of Figure 2, in accordance with one embodiment. The dashed lines indicate a graph of signals associated with the circuit of Figure 2. The solid lines indicate a graph of signals for the situation in which the leakage control circuit 112 is not present. As can be seen in the upper graph, when the negative supply voltage Neg is generated, the gate control signal applied to the gate terminal of the transistor T1 goes low. In the lower graph with solid lines, the gate control signal GC never goes below ground, possibly resulting in leakage currents.

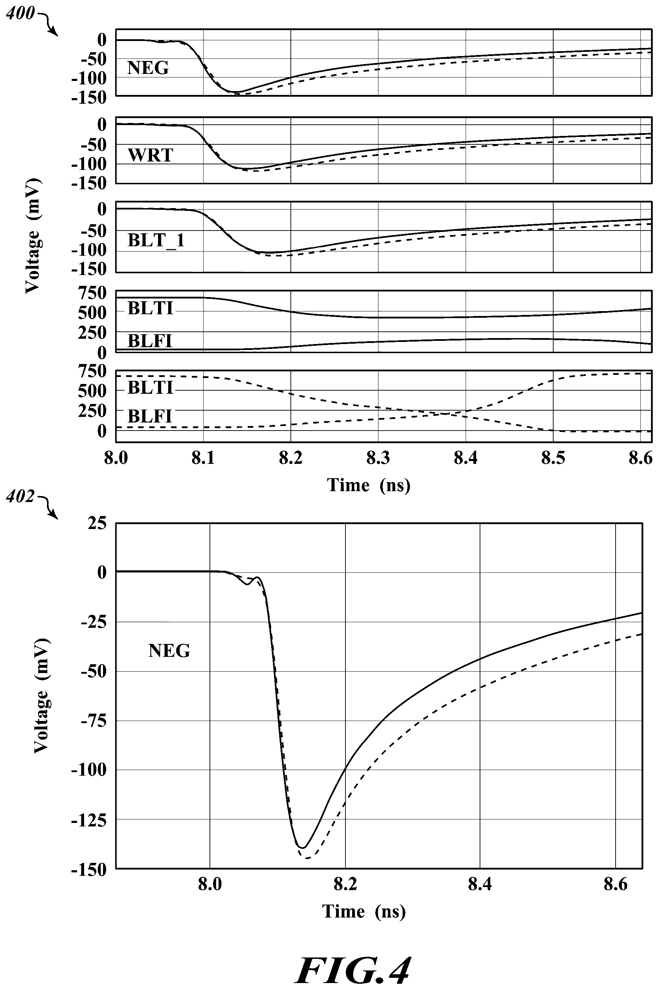

Figure 4 illustrates graphs 400 and 402 associated with the memory array 100 of Figure 2 during a write operation, in accordance with one embodiment. As set forth previously, the small, dashed lines correspond to the circuit of Figure 2, while the solid lines correspond to a situation in which the leakage control circuit 112 is not present.

The signals Neg, WRT, and BLT (for a situation in 0 is to be written on the selected true bitline) all go to a lower negative value and stay low longer in the embodiment of Figure 2. BLTI and BLFI correspond to the internal nodes of a bit cell, coupled respectively to BLT and BLF. In the graph 400, BLTI and BLFI are voltages in a selected bit-cell at an internal node at which the write operation writes data. Accordingly, the graph 400 illustrates the voltages on these internal nodes.

The graph 402 illustrate more clearly that the negative voltage signal Neg those lower and stays low longer than a solution that does not utilize the leakage control circuit 112. The result is that small capacitors C1/C2 can be utilized in accordance with principles of the present disclosure while achieving effective write operations and low power consumption. This reduces the overall area consumption. In one embodiment, the area of the capacitors C1/C2 is about 50 square micrometres.

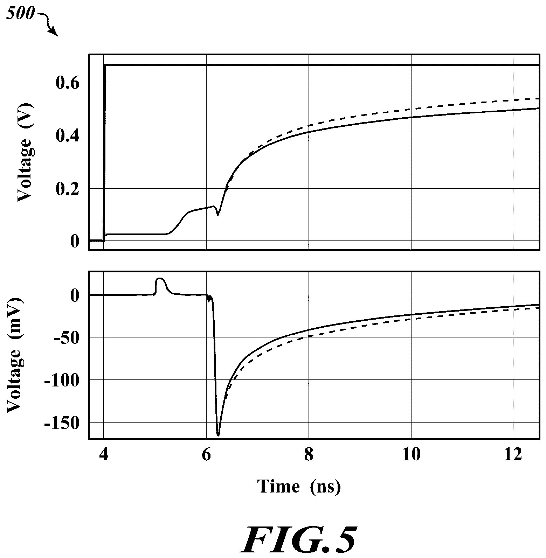

Figure 5 is a graph 500 illustrating signals associated with a write operation of the memory array 100 of Figure 2, in accordance with one embodiment. The graph 500 illustrates the negative voltage Neg, the word line voltage WL, and the voltage on false bitlines BLFI.

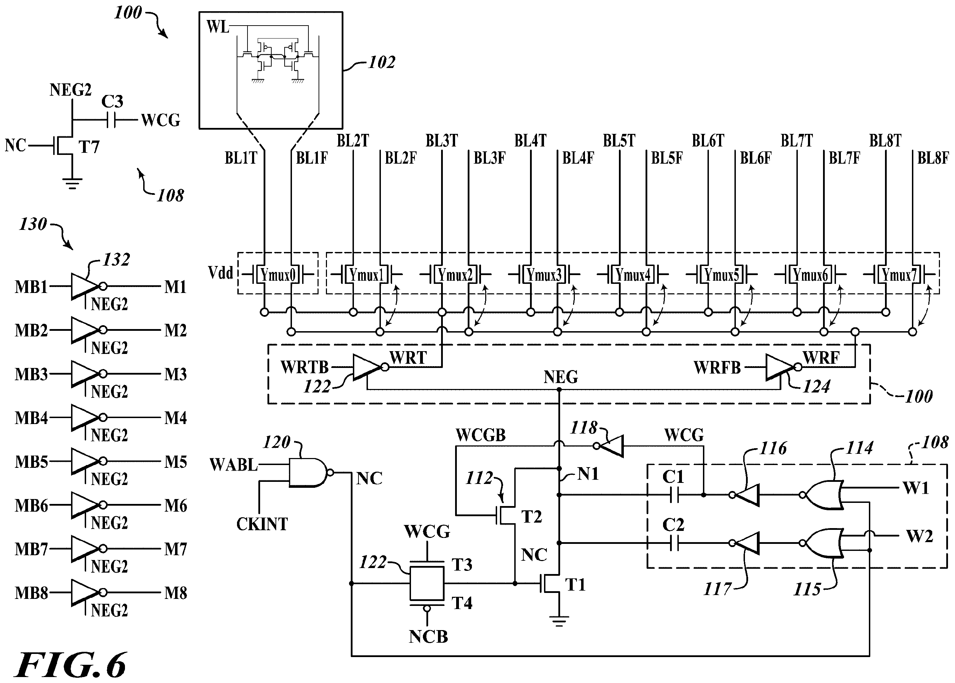

Figure 6 is a schematic diagram of a memory array 100, in accordance with one embodiment. The memory array 100 of Figure 6 is substantially similar in many regards to the memory array 100 of Figure 2. One difference is that the negative voltage generator includes a third capacitor C3 that generates a negative voltage Neg2 in conjunction with a transistor T7. The transistor T7 is substantially similar to the transistor T1. The negative voltage value Neg2 is generated to assist in reducing leakage currents associated with non-selected bit lines, as will be set forth in more detail below. Neg2 is generated in a manner substantially similar to the generation of Neg.

The memory array 100 includes a plurality of inverters 132 each associated with a respective multiplexer 106. The inverters each receive the negative voltage value Neg2 on their low supply terminals. Each inverter 132 receives a signal MB and outputs the complementary signal M to turn on or turn off the transistors of the multiplexers 106. Though not shown in Figure 6, each of the inverters 132 receives VDD and a high supply terminal. With Neg2 applied to the low supply terminal, when the output of the inverter 132 is low, Neg2 is provided as the output of the inverter 132.

When Neg is supplied to the non-selected bit lines below a multiplexer 106, Neg2 is applied to the gate terminal of the transistor of the corresponding multiplexer 106. In this way, the transistors of the non-selected bit lines remained nonconducting. This further reduces leakage currents and helps ensure that write operations are performed properly.

The memory array of Figure 6 provides many benefits. Capacitor area can be significantly reduced. The negative voltage peak can be lower (more negative). The duration of the negative voltage boost is increased. The duration of a write operation can be significantly reduced. The power consumption of a write operation can also be significantly reduced.

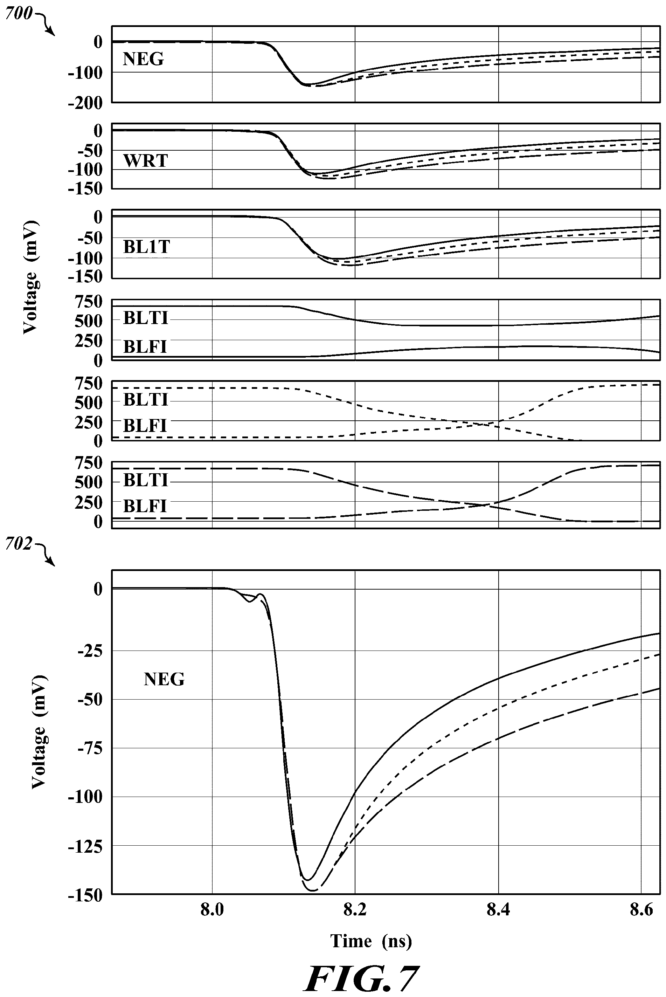

Figure 7 illustrates graphs associated with write operations of the memory array 100 of Figure 6, in accordance with one embodiment. The graph 700 illustrates the same signals as the graph 400, while the graph 702 illustrates the same signals as the graph 402. A larger dashed line in the graphs 700 and 702 represents performance of the memory array 100 of Figure 6. As can be seen, the negative voltage Neg those lower and stays low or for longer duration of time in the memory array 100 of Figure 6.

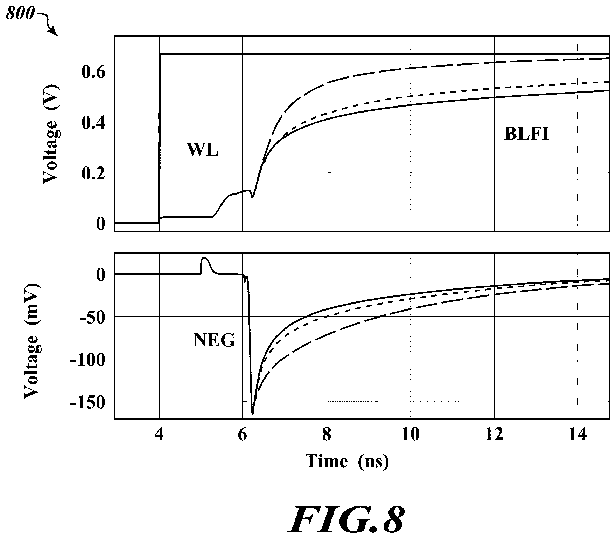

Figure 8 illustrates a graph 800 including signals associated with the memory array 100 of Figure 6, in accordance with one embodiment. The graph 800 is substantially similar to the graph 500 of Figure 5, except that a larger dashed lines are included representing signals associated with the memory array 100 of Figure 6. As can be seen in Figure 8, the false bitline voltage goes higher in the circuit of Figure 6, while the negative voltage Neg stays low or longer in the memory array 100 of Figure 6.

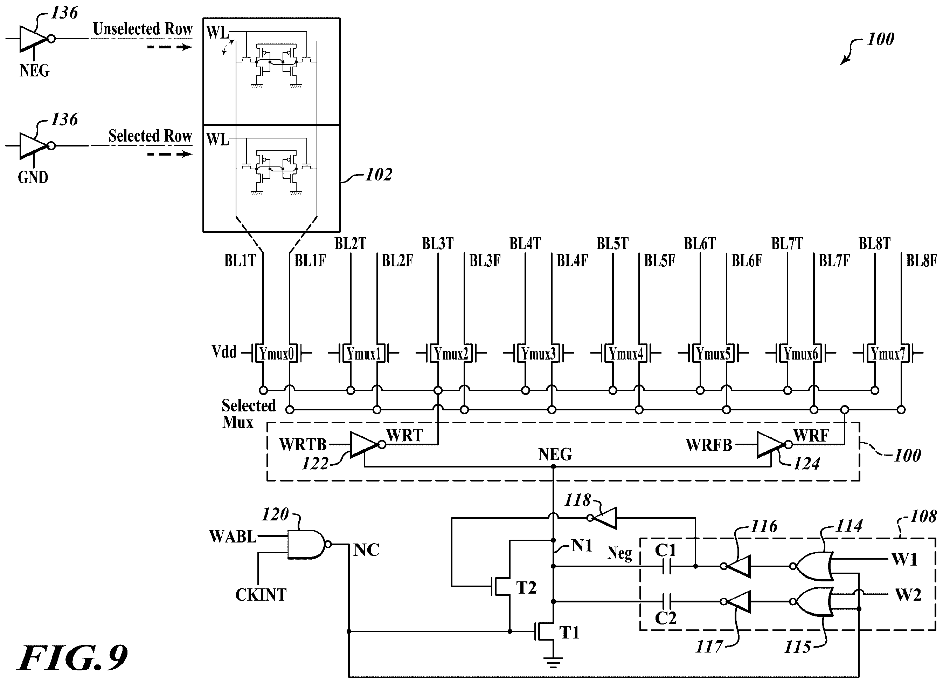

Figure 9 is a schematic diagram of a memory array 100, in accordance with some embodiments. The memory array 100 of Figure 9 is substantially similar to the memory array 100 of Figure 2. Figure 9 illustrates a plurality of inverters 136 each coupled to a word line of a row of the memory array 100. The output of the inverter 136 is provided to the word line WL. For an unselected row during a write operation, a negative voltage Neg is provided to the low supply terminal of the inverter 136. The result is that the word line WL of the unselected row is brought to the negative voltage Neg. This further reduces leakages and enhances the effectiveness and efficiency of write operations. The negative voltage Neg applied to the inverters 136 can correspond to Neg is generated at N1. Alternatively, the inverters 136 can receive Neg2, or a negative voltage generated by a separate negative voltage generator 108 not shown. The low supply terminal of the inverter 136 for a selected row receives ground.

The memory array of Figure 9 provides many benefits. Capacitor area can be significantly reduced. The negative voltage peak can be lower (more negative). The duration of the negative voltage boost is increased. The duration of a write operation can be significantly reduced. The power consumption of a write operation can also be significantly reduced.

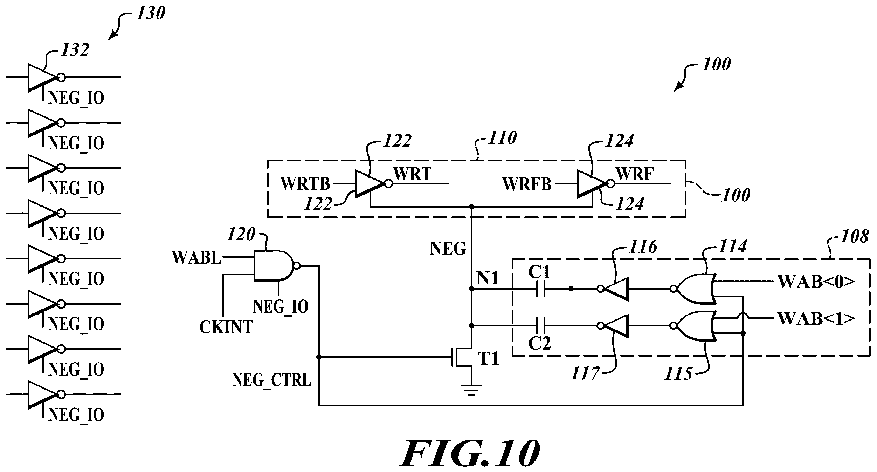

Figure 10 is a schematic diagram of a memory array 100, in accordance with some embodiments. The bit lines in memory cells are not shown in Figure 10 for simplicity. In Figure 10, when the negative voltage Neg is generated at the node N1, the NAND gate 120 receives a negative voltage NEG_IO at the low supply terminal of the NAND gate 120. The result is that the NAND gate 120 outputs the negative voltage NEG_IO to the gate terminal of the transistor T1. Neg_IO can be generated by a same negative voltage generator 108 or by a different negative voltage generator 108 than shown in Figure 10. Neg_IO is also applied to the low supply terminals of the inverters 132, which in turn supply Neg_IO to the multiplexers of non-selected bit lines, as described previously.

The memory array of Figure 10 provides many benefits. Capacitor area can be significantly reduced. The negative voltage peak can be lower (more negative). The duration of the negative voltage boost is increased. The duration of a write operation can be significantly reduced. The power consumption of a write operation can also be significantly reduced.

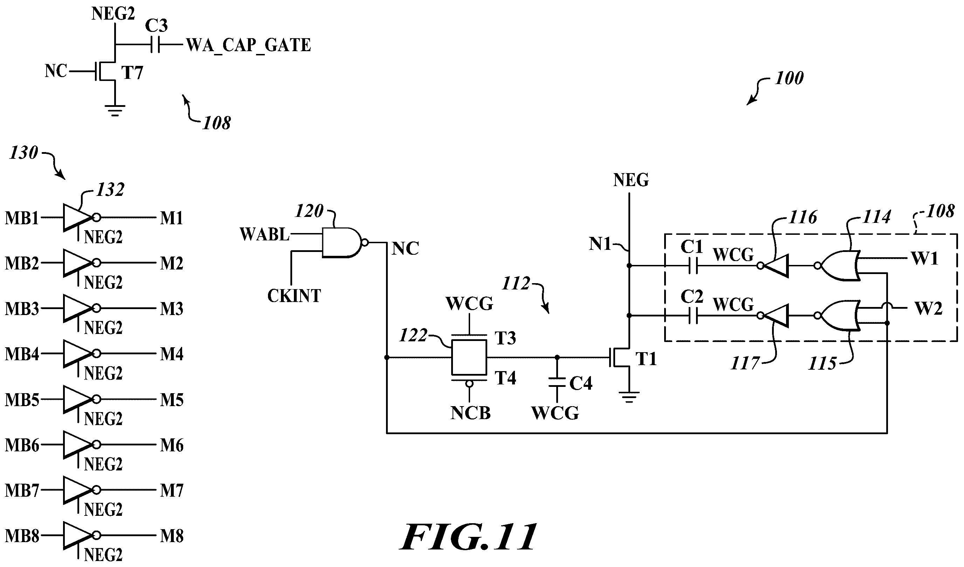

Figure 11 is a schematic diagram of a memory array 100, in accordance with some embodiments. The memory array 100 of Figure 11 is substantially similar to the memory array 100 of Figure 2, except that the leakage control circuit 112 includes a capacitor C4 coupled to the gate terminal of the transistor T1. The signal WCG that is applied to the capacitors C1 and C2 is also applied to the capacitor C4. The result is that when the negative voltage Neg is generated at the node N1, at the gate terminal of the transistor T1 in a similar manner. The result is that the transistor T1 remain substantially nonconducting during the write operation. Figure 11 also illustrates the negative voltage generator 108 that generates Neg2, as described in relation to Figure 6. Figure 11 also illustrates how Neg2 is applied to non-selected multiplexers, as described in relation to Figure 6.

The memory array of Figure 11 provides many benefits. Capacitor area can be significantly reduced. The negative voltage peak can be lower (more negative). The duration of the negative voltage boost is increased. The duration of a write operation can be significantly reduced. The power consumption of a write operation can also be significantly reduced.

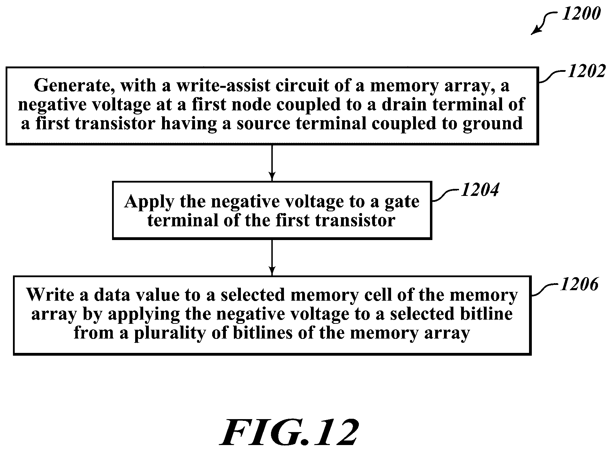

Figure 12 is a flow diagram of a method 1200 for operating a memory array, in accordance with some embodiments. The method 1200 can utilize processes, systems, and components described in relation to Figures 1-11. At 1202, the method 1200 includes generating, with a write assist circuit of a memory array, a first negative voltage at a first node coupled to a drain terminal of a first transistor. At 1204, the method 1200 includes applying the first negative voltage to a gate terminal of the first transistor. at 1206, the method 1200 includes writing a data value to a selected memory cell of the memory array by applying the first negative voltage to a selected bitline from a plurality of bitlines of the memory array.

In one embodiment, a method includes generating, with a write assist circuit of a memory array, a first negative voltage at a first node coupled to a drain terminal of a first transistor. The method includes applying the first negative voltage to a gate terminal of the first transistor and writing a data value to a selected memory cell of the memory array by applying the first negative voltage to a selected bitline from a plurality of bitlines of the memory array.

In one embodiment, a device includes a memory array including a plurality of memory cells and a plurality of bitlines coupled to the memory cells and a write assist circuit coupled to the memory array. The write assist circuit includes a negative voltage generator configured to generate a first negative voltage at a first node of the write assist circuit during a write operation of the memory cells. a first transistor having a gate terminal and a first source/drain terminal coupled to the first node, and a leakage control circuit configured to apply a second negative voltage to the gate terminal of the first transistor during a write operation of the memory array.

In one embodiment, a device includes a memory array including a plurality of memory cells and a plurality of bitlines. The memory array includes a write assist circuit configured to generate a first negative voltage and a second negative voltage during a write operation of the memory array and to apply the first negative voltage to a selected bitline of the plurality of bitlines during the write operation. The memory array includes a first inverter coupled to the memory array, wherein the write assist circuit is configured to supply the second negative voltage to a supply terminal of the first inverter during the write operation.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A method, comprising:
generating, with a write assist circuit of a memory array, a first negative voltage at a first node coupled to a drain terminal of a first transistor;
applying the first negative voltage to a gate terminal of the first transistor; and
writing a data value to a selected memory cell of the memory array by applying the first negative voltage to a selected bitline from a plurality of bitlines of the memory array.

2. The method of claim **1,** comprising generating the negative voltage across a capacitor having a first terminal coupled to the first node.

3. The method of claim 2, wherein applying the first negative voltage to the gate terminal of the first transistor includes turning on a second transistor having first terminal coupled to the first node and a second terminal coupled to the gate terminal of the first transistor.

4. The method of claim 3, wherein turning on the transistor includes applying a high supply voltage to a gate terminal of the second transistor via an inverter having an input coupled to a second terminal of the capacitor and an output coupled to the gate terminal of the second transistor.

5. The method of claim 1, wherein applying the first negative voltage to the gate terminal of the first transistor includes opening a pass gate coupled to the gate terminal of the first transistor.

6. The method of claim 1, comprising:
generating a second negative voltage with the write assistance circuit; and
applying the second negative voltage to a plurality of multiplexers each coupled to a respective non-selected bitline of the memory array.

7. The method of claim 6, wherein applying the second negative voltage to the plurality of multiplexers includes applying the second negative voltage to a plurality of inverters each coupled to a respective multiplexer of the plurality of multiplexers.

8. The method of claim 7, wherein applying the second negative voltage to the plurality of inverters includes applying the negative voltage to respective low supply terminals of the plurality of inverters.

9. The method of claim 1, comprising:
generating a second negative voltage with the write assistance circuit; and
applying the second negative voltage to a non-selected wordline of the memory array.

10. The method of claim 9, wherein applying the second negative voltage to the non-selected word line includes applying the negative voltage to a low supply terminal of the plurality of inverters.

11. A device, comprising:
a memory array including a plurality of memory cells and a plurality of bitlines coupled to the memory cells; and
a write assist circuit coupled to the memory array including:
a negative voltage generator configured to generate a first negative voltage at a first node of the write assist circuit during a write operation of the memory cells;
a first transistor having a gate terminal and a first source/drain terminal coupled to the first node; and
a leakage control circuit configured to apply a second negative voltage to the gate terminal of the first transistor during a write operation of the memory array.

12. The device of claim 11, wherein the write assist circuit includes a first capacitor having a first terminal coupled to the first node, wherein the write assist circuit is configured to generate the first negative voltage across the capacitor having a first terminal coupled to the first node.

13. The device of claim 12, wherein the leakage control circuit includes a second transistor having a first source/drain terminal coupled to the first node and a second source/drain terminal coupled to the gate terminal of the first transistor.

14. The device of claim 13, wherein the leakage control circuit includes an inverter having an input coupled to a second terminal of the capacitor and an output coupled to the gate terminal of the second transistor.

15. The device of claim 11, wherein the leakage control circuit includes a pass gate coupled to the gate terminal of the first transistor.

16. The device of claim 11, comprising a plurality of multiplexers each coupled to a respective bitline, wherein the write assistance circuit is configured to generate a second negative voltage and to apply the second negative voltage to one of the multiplexers of the plurality of multiplexers not selected for the write operation.

17. The device of claim 16, comprising an inverter coupled to the multiplexer, wherein the write assistance circuit is configured to apply the second negative voltage to the multiplexer by applying the second negative voltage to a low supply terminal of the inverter.

18. The device of claim 11, comprising a wordline coupled to the memory array wherein the write assistance circuit is configured to:
generate a second negative voltage during the write operation; and
apply the second negative voltage to a wordline of the memory array during the write operation.

19. The device of claim 18, comprising an inverter coupled to the wordline, wherein the write assist circuit is configured to apply the second negative voltage to the word line by applying the negative voltage to a low supply terminal of the inverter.

20. A device, comprising:
a memory array including a plurality of memory cells and a plurality of bitlines;
a write assist circuit configured to generate a first negative voltage and a second negative voltage during a write operation of the memory array and to apply the first negative voltage to a selected bitline of the plurality of bitlines during the write operation; and
a first inverter coupled to the memory array, wherein the write assist circuit is configured to supply the second negative voltage to a supply terminal of the first inverter during the write operation.

21. The device of claim 20, comprising a second inverter coupled between the write assistance circuit and the plurality of bitlines and having a supply terminal coupled to receive the first negative voltage during the write operation.

22. The device of claim 20, wherein the write assistance circuit includes:
a first node configured to receive the first negative voltage;
a first transistor having a first source/drain terminal coupled to the first node, a second source/drain terminal coupled to ground, and a gate terminal; and
a second transistor having a first source/drain terminal coupled to the first node and a second source/drain terminal coupled to the gate terminal of the first transistor.
